(19) Europäisches Patentamt
European Patent Office
Office européen des brevets

(11) **EP 2 600 402 A1**

(12) **EUROPEAN PATENT APPLICATION**
published in accordance with Art. 153(4) EPC

(43) Date of publication:
**05.06.2013 Bulletin 2013/23**

(51) Int Cl.:
**H01L 29/12** (2006.01)   **H01L 29/78** (2006.01)

(21) Application number: **11812210.0**

(22) Date of filing: **29.06.2011**

(86) International application number:
**PCT/JP2011/064897**

(87) International publication number:
**WO 2012/014617 (02.02.2012 Gazette 2012/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.01.2011 JP 2011012510
26.07.2010 JP 2010167004**

(71) Applicant: **Sumitomo Electric Industries, Ltd.
Chuo-ku
Osaka-shi
Osaka 541-0041 (JP)**

(72) Inventors:
• **HIYOSHI, Toru
Osaka-shi
Osaka 554-0024 (JP)**

• **WADA, Keiji
Osaka-shi
Osaka 554-0024 (JP)**
• **MASUDA, Takeyoshi
Osaka-shi
Osaka 554-0024 (JP)**
• **SHIOMI, Hiromu
Osaka-shi
Osaka 554-0024 (JP)**

(74) Representative: **Grünecker, Kinkeldey,
Stockmair & Schwanhäusser
Leopoldstrasse 4
80802 München (DE)**

(54) **SEMICONDUCTOR DEVICE**

(57)    A MOSFET (100) includes a silicon carbide substrate (1) including a main surface (1A) having an off angle of not less than 50° and not more than 65° with respect to a {0001} plane, a buffer layer (2) and a drift layer (3) formed on the main surface (1A), a gate oxide film (91) formed on and in contact with the drift layer (3), and a p type body region (4) of a p conductivity type formed in the drift layer (3) to include a region in contact with the gate oxide film (91). The p type body region (4) has a p type impurity density of not less than $5 \times 10^{16}$ cm$^{-3}$

FIG.1

EP 2 600 402 A1

**Description**

TECHNICAL FIELD

The present invention relates to semiconductor devices, and more particularly to a semiconductor device capable of achieving increased flexibility in setting a threshold voltage while achieving suppressed reduction in channel mobility.

BACKGROUND ART

In recent years, silicon carbide has been increasingly used as a material for a semiconductor device in order to realize a higher breakdown voltage, loss reduction, use in a high-temperature environment and the like of the semiconductor device. Silicon carbide is a wide band gap semiconductor having a wider band gap than that of silicon which has been conventionally and widely used as a material for a semiconductor device. By using silicon carbide as a material for a semiconductor device, therefore, a higher breakdown voltage, on-resistance reduction and the like of the semiconductor device can be achieved. A semiconductor device made of silicon carbide also has the advantage of exhibiting less performance degradation when used in a high-temperature environment than a semiconductor device made of silicon.

For semiconductor devices such as MOSFETs (Metal Oxide Semiconductor Field Effect Transistors) and IGBTs (Insulated Gate Bipolar Transistors) among the semiconductor devices made of silicon carbide, in which presence or absence of formation of an inversion layer in a channel region is controlled with a prescribed threshold voltage as a boundary to conduct or interrupt a current, various studies have been conducted on adjustment of a threshold voltage and improvement in channel mobility (see Sei-Hyung Ryu et al., "Critical Issues for MOS Based Power Devices in 4H-SiC," Materials Science Forum, 2009, Vols. 615-617, pp. 743-748 (Non-Patent Literature 1), for example).

CITATION LIST

NON-PATENT LITERATURE

NPL 1: Sei-Hyung Ryu et al., "Critical Issues for MOS Based Power Devices in 4H-SiC," Materials Science Forum, 2009, Vols. 615-617, pp. 743-748

SUMMARY OF INVENTION

TECHNICAL PROBLEM

In a semiconductor device such as an N channel MOSFET or IGBT, a p type body region of a p conductivity type is formed, and a channel region is formed in the p type body region. By increasing the density (doping density) of a p type impurity (B (boron) and/or Al (aluminum), for example) in the p type body region, a threshold voltage can be shifted to a positive side, and the device can be brought closer to a normally off type or made as a normally off type. In a P channel semiconductor device, contrary to the N channel device, by increasing the density of an n type impurity in an n type body region, a threshold voltage can be shifted to a negative side, and the device can be brought closer to a normally off type or made as a normally off type.

The adjustment of a threshold voltage in this manner results in significant reduction in channel mobility, however. This is because increasing the doping density causes noticeable scattering of electrons due to a dopant. For this reason, the doping density in a p type body region is set to approximately $1 \times 10^{16}$ cm$^{-3}$ to $4 \times 10^{16}$ cm$^{-3}$, for example. Consequently, it has been difficult to freely set a threshold voltage while ensuring a sufficient channel mobility in a conventional semiconductor device, particularly to bring the device closer to a normally off type or make the device as a normally off type.

The present invention was made to solve such problems, and an object of the present invention is to provide a semiconductor device capable of achieving increased flexibility in setting a threshold voltage while achieving suppressed reduction in channel mobility.

SOLUTION TO PROBLEM

A semiconductor device according to the present invention includes a silicon carbide substrate including a main surface having an off angle of not less than 50° and not more than 65° with respect to a {0001} plane, an epitaxial growth layer of a first conductivity type formed on the main surface, an insulating film formed on and in contact with the epitaxial growth layer, and a body region of a second conductivity type different from the first conductivity type formed in the epitaxial growth layer to include a region in contact with the insulating film. The body region has an impurity density of not less than $5 \times 10^{16}$ cm$^{-3}$

The present inventors conducted a detailed study of methods for increasing flexibility in setting a threshold voltage while suppressing reduction in channel mobility, and arrived at the present invention based on the following findings. In a conventional semiconductor device made of silicon carbide, a silicon carbide substrate including a main surface having an off angle of not more than approximately 8° with respect to the {0001} plane is used. An epitaxial growth layer and the like are formed on the main surface to fabricate the semiconductor device. In such semiconductor device, it is difficult to freely set a threshold voltage while ensuring a sufficient channel mobility as described above. According to the study by the present inventors, however, it was found that opposing relation between increase in doping density in a body region and improvement in channel mobility was significantly relieved if the off angle of the main surface of the silicon carbide substrate with respect to the {0001} plane was within a prescribed range. More specifically, in a structure including a silicon carbide substrate including a main surface having an off angle of not less than 50° and not more than 65° with respect to the {0001} plane, and an epitaxial growth layer formed on the main surface, if a body region is formed by introducing an impurity (B or Al which is a p type impurity, for example) into this epitaxial growth layer, reduction in channel mobility is significantly suppressed even if a doping density in the body region is increased.

In the semiconductor device of the present invention, the silicon carbide substrate including the main surface having an off angle of not less than 50° and not more than 65° with respect to the {0001} plane is used, and the body region is formed in the epitaxial growth layer formed on the main surface. Accordingly, even if a highly doped body region having an impurity density of not less than $5 \times 10^{16}$ cm$^{-3}$ is formed and the threshold voltage is shifted to a positive side, reduction in channel mobility is suppressed. According to the present invention, therefore, a semiconductor device capable of achieving increased flexibility in setting a threshold voltage while achieving suppressed reduction in channel mobility can be provided. It is noted that the "'impurity" mentioned above refers to an impurity which generates majority carriers by being introduced into silicon carbide.

In the semiconductor device described above, an angle formed between an off orientation of the main surface and a <01-10> direction may be not more than 5°.

The <01-10> direction is a representative off orientation in a silicon carbide substrate. By setting variation in off orientation resulting from variation which occurs during slicing operation or the like in the course of manufacturing the substrate to not more than 5°, formation of the epitaxial growth layer on the silicon carbide substrate and the like can be facilitated.

In the semiconductor device described above, the main surface may have an off angle of not less than -3° and not more than 5° with respect to a {03-38} plane in the <01-10> direction.

As a result, the channel mobility can be further improved. The reason that the off angle with respect to the plane orientation {03-38} is not less than -3° and not more than 5° is based on the examination results of relation between the channel mobility and the off angle, which showed that a particularly high channel mobility was obtained within this range.

The "off angle with respect to the {03-38} plane in the <01-10> direction" refers to an angle formed between an orthogonal projection of a normal of the main surface to a plane including the <01-10> direction and the <0001> direction and a normal of the {03-38} plane, and a sign thereof is positive when the orthogonal projection approaches to become parallel to the <01-10> direction, and negative when the orthogonal projection approaches to become parallel to the <0001> direction.

It is more preferable that the plane orientation of the main surface be substantially the {03-38} plane, and it is still more preferable that the plane orientation of the main surface be the {03-38} plane. That the plane orientation of the main surface is substantially the {03-38} plane means that the plane orientation of the main surface of the substrate is within a range of an off angle where the plane orientation can substantially be regarded as the {03-38} plane, and the range of the off angle in this case is a range of $\pm 2°$ of the off angle with respect to the {03-38} plane. As a result, the channel mobility can be further improved.

In the semiconductor device described above, an angle formed between the off orientation of the main surface and a <-2110> direction may be not more than 5°.

Like the <01-10> direction described above, the <-2110> direction is a representative off orientation in a silicon carbide substrate. By setting variation in off orientation resulting from variation which occurs during slicing operation or the like in the course of manufacturing the substrate to $\pm 5°$, formation of the epitaxial growth layer on the silicon carbide substrate and the like can be facilitated.

In the semiconductor device described above, the main surface may be a surface of a carbon face side of silicon carbide forming the silicon carbide substrate.

Consequently, the channel mobility can be further improved. Here, the (0001) plane of single-crystalline silicon carbide of a hexagonal crystal is defined as a silicon face, and the (000-1) plane is defined as a carbon face. That is, if a structure where an angle formed between the off orientation of the main surface and the <01-10> direction is not more than 5° is used, the main surface can be brought closer to a (0-33-8) plane, thereby further improving the channel mobility.

In the semiconductor device described above, the body region may have an impurity density of not more than $1 \times 10^{20}$ cm$^{-3}$.

Even if the body region has the impurity density of not more than $1 \times 10^{20}$ cm$^{-3}$, the threshold voltage can be set with sufficient flexibility. If the doping density is higher than $1 \times 10^{20}$ cm$^{-3}$, problems such as degradation in crystallinity may occur.

The semiconductor device described above may be of a normally off type. Even if the doping density in the body region is increased to a degree that makes the device as a normally off type in this manner, reduction in channel mobility can be sufficiently suppressed in the semiconductor device of the present invention.

The semiconductor device described above may further include a gate electrode arranged on and in contact with the insulating film, in which the gate electrode may be made of polysilicon of the second conductivity type. That is, when the second conductivity type is a p type, the gate electrode may be made of p type polysilicon, and when the second conductivity type is an n type, the gate electrode may be made of n type polysilicon. The p type polysilicon refers to polysilicon where the majority carriers are holes, and the n type polysilicon refers to polysilicon where the majority carriers are electrons. As a result, the semiconductor device can be readily made as a normally off type.

The semiconductor device described above may further include a gate electrode arranged on and in contact with the insulating film, in which the gate electrode may be made of n type polysilicon. As a result, switching speed of the semiconductor device can be improved.

In the semiconductor device described above, the insulating film may have a thickness of not less than 25 nm and not more than 70 nm. If the thickness of the insulating film is less than 25 nm, breakdown may occur during operation. If the thickness of the insulating film is more than 70 nm, an absolute value of a gate voltage when using this insulating film as a gate insulating film needs to be increased. Thus, the above problems can be readily resolved by setting the thickness of the insulating film to not less than 25 nm and not more than 70 nm.

In the semiconductor device described above, the first conductivity type may be an n type, and the second conductivity type may be a p type. That is, the semiconductor device described above may be of an N channel type. As a result, a semiconductor device where the majority carriers are electrons for which high mobility can be readily ensured can be provided.

In the semiconductor device described above, the body region may have an impurity density of not less than $8 \times 10^{16}$ cm$^{-3}$ and not more than $3 \times 10^{18}$ cm$^{-3}$ Consequently, a threshold voltage of approximately 0 to 5 V can be obtained at a normal operating temperature. As a result, a semiconductor device made of silicon can be readily replaced with the semiconductor device of the present application for use, and the semiconductor device can be steadily made as a normally off type. Further, significant reduction in channel mobility resulting from increase in impurity density can be avoided.

In the semiconductor device described above, a threshold voltage at which a weak inversion layer is formed in a region of the body region which is in contact with the insulating film may be not less than 2 V within a temperature range of from not less than room temperature and not more than 100°C. As a result, a normally off state can be more reliably maintained at the normal operating temperature. The room temperature specifically refers to 27°C.

In the semiconductor device described above, the threshold voltage may be not less than 3 V at 100°C. As a result, a normally off state can be more reliably maintained at a high operating temperature.

In the semiconductor device described above, the threshold voltage may be not less than 1 V at 200°C. As a result, a normally off state can be more reliably maintained at a higher operating temperature.

In the semiconductor device described above, the threshold voltage may have a temperature dependence of not less than -10 mV/°C. As a result, a normally off state can be stably maintained.

In the semiconductor device described above, a channel mobility of electrons at room temperature may be not less than 30 cm$^2$/Vs. As a result, on-resistance of the semiconductor device can be sufficiently suppressed.

In the semiconductor device described above, the channel mobility of electrons at 100°C may be not less than 50 cm$^2$/Vs. As a result, the on-resistance of the semiconductor device can be sufficiently suppressed at a high operating temperature.

In the semiconductor device described above, the channel mobility of electrons at 150°C may be not less than 40 cm$^2$/Vs. As a result, the on-resistance of the semiconductor device can be sufficiently suppressed at a higher operating temperature.

In the semiconductor device described above, the channel mobility of electrons may have a temperature dependence of not less than -0.3 cm$^2$/Vs °C. As a result, the on-resistance of the semiconductor device can be stably suppressed.

In the semiconductor device described above, a barrier height at an interface between the epitaxial growth layer and the insulating film may be not less than 2.2 eV and not more than 2.6 eV.

By increasing the barrier height, a leak current (tunnel current) flowing through the insulating film acting as a gate insulating film can be suppressed. When the epitaxial growth layer is made of silicon carbide, however, if a crystal face simply having a large barrier height with an insulating film is used as a surface in contact with the insulating film, the channel mobility is reduced. To address this problem, a crystal face having a barrier height of not less than 2.2 eV and not more than 2.6 eV is used as a surface in contact with the insulating film, thereby ensuring a high channel mobility while suppressing the leak current. Such barrier height can be readily achieved by using the silicon carbide substrate including the main surface having an off angle of not less than 50° and not more than 65° with respect to the {0001} plane. The barrier height refers to the size of a band gap between a conduction band of the epitaxial growth layer and a conduction band of the insulating film.

In the semiconductor device described above, channel resistance which is a resistance value in a channel region formed in the body region in an on state may be smaller than drift resistance which is a resistance value in the epitaxial growth layer other than the channel region. As a result, the on-resistance of the semiconductor device can be reduced. Such relation between the channel resistance and the drift resistance can be readily achieved by using the silicon carbide substrate including the main surface having an off angle of not less than 50° and not more than 65° with respect to the {0001} plane.

The semiconductor device described above may be a DiMOSFET (Double Implanted MOSFET). The semiconductor device of the present invention is also suitable for a DiMOSFET having a relatively simple structure.

ADVANTAGEOUS EFFECTS OF INVENTION

As is clear from the description above, according to the present invention, a semiconductor device capable of achieving increased flexibility in setting a threshold voltage while achieving suppressed reduction in channel mobility can be provided.

BRIEF DESCRIPTION OF DRAWINGS

Fig. 1 is a schematic cross-sectional view showing a structure of a MOSFET in a first embodiment.
Fig. 2 is a flowchart schematically illustrating a method of manufacturing the MOSFET in the first embodiment.
Fig. 3 is a schematic cross-sectional view for explaining the method of manufacturing the MOSFET in the first embodiment.
Fig. 4 is a schematic cross-sectional view for explaining the method of manufacturing the MOSFET in the first embodiment.
Fig. 5 is a schematic cross-sectional view for explaining the method of manufacturing the MOSFET in the first embodiment.
Fig. 6 illustrates heat patterns of NO annealing and Ar annealing.
Fig. 7 is a schematic cross-sectional view showing a structure of an IGBT in a second embodiment.
Fig. 8 is a flowchart schematically illustrating a method of manufacturing the IGBT in the second embodiment.
Fig. 9 is a schematic cross-sectional view for explaining the method of manufacturing the IGBT in the second embodiment.
Fig. 10 is a schematic cross-sectional view for explaining the method of manufacturing the IGBT in the second embodiment.
Fig. 11 is a schematic cross-sectional view for explaining the method of manufacturing the IGBT in the second embodiment.
Fig. 12 illustrates relation between a doping density of a p type impurity and a threshold voltage.
Fig. 13 illustrates relation between a doping density and a channel mobility when the (0-33-8) plane is used as a main surface of a substrate.
Fig. 14 illustrates relation between a doping density and a channel mobility when the (0001) plane is used as a main surface of a substrate.
Fig. 15 is a diagram for determining a threshold voltage from values of a gate voltage and a drain current.
Fig. 16 illustrates relation between a temperature and a threshold voltage.
Fig. 17 illustrates relation between a temperature and a channel mobility.
Fig. 18 illustrates relation between a doping density and a threshold voltage.

DESCRIPTION OF EMBODIMENTS

Embodiments of the present invention will be described hereinafter with reference to the drawings. It is noted that the same or corresponding parts have the same reference numerals allotted in the drawings, and description thereof will not be repeated. In the present specification, an individual orientation is indicated with [], a group orientation is indicated with <>, an individual plane is indicated with (), and a group plane is indicated with {}. Although "-" (bar) is supposed to be attached atop a numeral of an negative index in terms of crystallography, a negative sign is attached before a numeral in the present specification.

(First Embodiment)

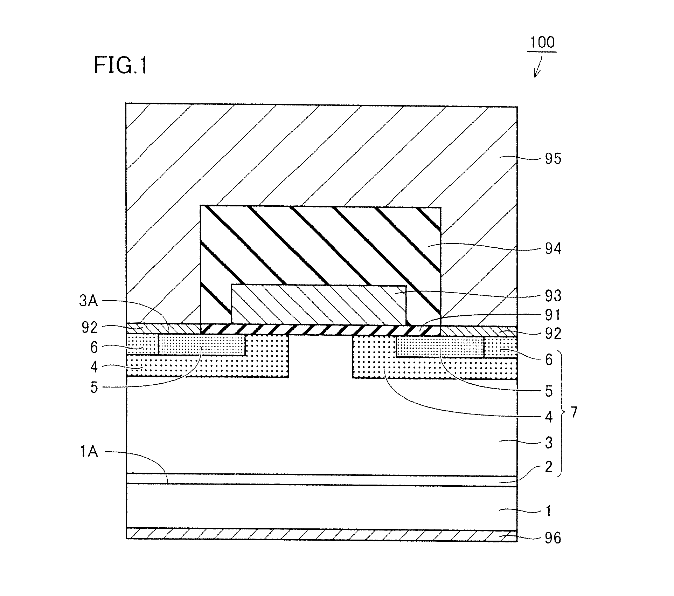

A first embodiment which is one embodiment of the present invention will be first described. Referring to Fig. 1, a MOSFET 100 which is a semiconductor device (DiMOSFET) in this embodiment includes a silicon carbide substrate 1 of an n conductivity type (first conductivity type), a buffer layer 2 of the n conductivity type made of silicon carbide, a drift layer 3 of the n conductivity type made of silicon carbide, a pair of p type body regions 4 of a p conductivity type (second conductivity type), $n^+$ regions 5 of the n conductivity type, and $p^+$ regions 6 of the p conductivity type.

Buffer layer 2 is formed on one main surface 1A of silicon carbide substrate 1, and is of the n conductivity type by containing an n type impurity. Drift layer 3 is formed on buffer layer 2, and is of the n conductivity type by containing an n type impurity. The n type impurity contained in drift layer 3 is N (nitrogen), for example, and contained in a concentration (density) lower than that of the n type impurity contained in buffer layer 2. Buffer layer 2 and drift layer 3 constitute an epitaxial growth layer formed on one main surface 1A of silicon carbide substrate 1.

The pair of p type body regions 4 is formed apart from each other in the epitaxial growth layer to include a main surface 3A opposite to a main surface closer to silicon carbide substrate 1, and is of the p conductivity type by containing a p type impurity (an impurity of the p conductivity type). The p type impurity contained in p type body regions 4 is aluminum (Al) and/or boron (B), for example.

Each of $n^+$ regions 5 is formed in each of the pair of p type body regions 4 to include main surface 3A and be surrounded by each of p type body regions 4. $N^+$ regions 5 contain an n type impurity such as P in a concentration (density) higher than that of the n type impurity contained in drift layer 3. Each of $p^+$ regions 6 is formed in each of the pair of p type body regions 4 to include main surface 3A, be surrounded by each of p type body regions 4, and be adjacent to each of $n^+$ regions 5. $P^+$ regions 6 contain a p type impurity such as Al in a concentration (density) higher than that of the p type impurity contained in p type body regions 4. Buffer layer 2, drift layer 3, p type body regions 4, $n^+$ regions 5 and $p^+$ regions 6 constitute an active layer 7.

Referring to Fig. 1, MOSFET 100 further includes a gate oxide film 91 as a gate insulating film, a gate electrode 93, a pair of source contact electrodes 92, an interlayer insulating film 94, a source line 95, and a drain electrode 96.

Gate oxide film 91 is formed on and in contact with main surface 3A of the epitaxial growth layer to extend from an upper surface of one of $n^+$ regions 5 to an upper surface of the other $n^+$ region 5, and is made of silicon dioxide ($SiO_2$), for example.

Gate electrode 93 is arranged in contact with gate oxide film 91 to extend from above one of $n^+$ regions 5 to above the other $n^+$ region 5. Gate electrode 93 is formed of a conductor such as polysilicon including an impurity or Al.

Each of source contact electrodes 92 is arranged in contact with main surface 3A to extend from above each of the pair of $n^+$ regions 5 in a direction away from gate oxide film 91 to reach a portion above each of $p^+$ regions 6. Source contact electrodes 92 are made of a material capable of making ohmic contact with $n^+$ regions 5, such as $Ni_xSi_y$ (nickel silicide).

Interlayer insulating film 94 is formed to surround gate electrode 93 above main surface 3A of drift layer 3 and extend from above one of p type body regions 4 to above the other p type body region 4, and is made of silicon dioxide ($SiO_2$ which is an insulator, for example.

Source line 95 surrounds interlayer insulating film 94 above main surface 3A of drift layer 3, and extends to upper surfaces of source contact electrodes 92. Source line 95 is formed of a conductor such as Al, and electrically connected to $n^+$ regions 5 via source contact electrodes 92.

Drain electrode 96 is formed in contact with a main surface of silicon carbide substrate 1 opposite to the surface on which drift layer 3 is formed. Drain electrode 96 is made of a material capable of making ohmic contact with silicon carbide substrate 1, such as $Ni_xSi_y$, and electrically connected to silicon carbide substrate 1.

Next, operation of MOSFET 100 will be described. Referring to Fig. 1, when gate electrode 93 has a voltage lower than a threshold voltage, i.e., in an off state, a pn junction between each of p type body regions 4 and drift layer 3 positioned immediately below gate oxide film 91 is reverse biased and non-conducting even if a voltage is applied to the drain electrode. On the other hand, when a voltage higher than the threshold voltage is applied to gate electrode 93, an inversion layer is formed in a channel region in p type body region 4 which is in contact with gate oxide film 91. As a result, $n^+$ regions 5 and drift layer 3 are electrically connected to each other, causing a current to flow between source line 95 and drain electrode 96.

In MOSFET 100, main surface 1A of silicon carbide substrate 1 has an off angle of not less than 50° and not more than 65° with respect to the {0001} plane. Accordingly, even if highly doped p type body regions 4 having a p type impurity density of not less than $5 \times 10^{16}$ cm$^{-3}$ are formed and the threshold voltage is shifted to a positive side, reduction in mobility of carriers (electrons) (channel mobility) in the channel region is suppressed. Therefore, MOSFET 100 can be brought closer to an normally off type or made as a normally off type by the shift of the threshold voltage to a positive side while reduction in channel mobility is suppressed. To further shift the threshold voltage to a positive side, the p type impurity density in p type body regions 4 may be not less than $1 \times 10^{17}$ cm$^{-3}$, or even not less than $5 \times 10^{17}$ cm$^{-3}$.

It is preferable that an angle formed between an off orientation of main surface 1A of silicon carbide substrate 1 and a <01-10> direction be not more than 5°. This can facilitate formation of the epitaxial growth layer (buffer layer 2 and drift layer 3) on silicon carbide substrate 1 and the like.

It is preferable that main surface 1 A have an off angle of not less than -3° and not more than 5° with respect to a {03-38} plane in the <01-10> direction, and it is more preferable that main surface 1A be substantially the {03-38} plane. As a result, the channel mobility can be further improved.

In MOSFET 100, an angle formed between the off orientation of main surface 1A and a <-2110> direction may be not more than 5°. This can facilitate formation of the epitaxial growth layer (buffer layer 2 and drift layer 3) on silicon carbide substrate 1 and the like.

It is preferable that main surface 1A be a surface of a carbon face side of silicon carbide forming silicon carbide substrate 1. As a result, the channel mobility can be further improved.

It is preferable that p type body regions 4 have a p type impurity density of not more than $1 \times 10^{20}$ cm$^{-3}$. As a result, degradation in crystallinity and the like can be suppressed.

MOSFET 100 may be of a normally off type. Even if the doping density in the p type body regions is increased to a degree that makes MOSFET 100 as a normally off type in this manner, reduction in channel mobility can be sufficiently suppressed in MOSFET 100.

In MOSFET 100, gate electrode 93 may be made of p type polysilicon. As a result, the threshold voltage can readily be shifted to a positive side, and MOSFET 100 can be readily made as a normally off type.

In MOSFET 100, gate electrode 93 may be made of n type polysilicon. As a result, switching speed of MOSFET 100 can be improved.

In MOSFET 100, p type body regions 4 may have a p type impurity density of not less than $8 \times 10^{16}$ cm$^{-3}$ and not more than $3 \times 10^{18}$ cm$^{-3}$ Consequently, a threshold voltage of approximately 0 to 5 V can be obtained at a normal operating temperature. As a result, a MOSFET made of silicon can be readily replaced with MOSFET 100 for use, and MOSFET 100 can be stably made as a normally off type. Further, significant reduction in channel mobility resulting from increase in impurity density can be avoided.

In MOSFET 100, gate oxide film 91 may have a thickness of not less than 25 nm and not more than 70 nm. If the thickness of gate oxide film 91 is less than 25 nm, breakdown may occur during operation, whereas if the thickness is more than 70 nm, a gate voltage needs to be increased. It is thus preferable that gate oxide film 91 have a thickness of not less than 25 nm and not more than 70 nm.

In MOSFET 100, the threshold voltage may be not less than 2 V within a temperature range of from not less than room temperature and not more than 100°C. As a result, a normally off state can be more reliably maintained at the normal operating temperature.

In MOSFET 100, the threshold voltage may be not less than 3 V at 100°C. As a result, a normally off state can be more reliably maintained at a high operating temperature.

In MOSFET 100, the threshold voltage may be not less than 1 V at 200°C. As a result, a normally off state can be more reliably maintained at a higher operating temperature.

In MOSFET 100, the threshold voltage may have a temperature dependence of not less than -10 mV/°C. As a result, a normally off state can be stably maintained.

In MOSFET 100, it is preferable that a channel mobility of electrons at room temperature be not less than 30 cm$^2$/Vs. As a result, on-resistance of MOSFET 100 can be sufficiently suppressed.

In MOSFET 100, the channel mobility of electrons at 100°C may be not less than 50 cm$^2$/Vs. As a result, the on-resistance of MOSFET 100 can be sufficiently suppressed at a high operating temperature.

In MOSFET 100, the channel mobility of electrons at 150°C may be not less than 40 cm$^2$/Vs. As a result, the on-resistance of MOSFET 100 can be sufficiently suppressed at a higher operating temperature.

In MOSFET 100, the channel mobility of electrons may have a temperature dependence of not less than -0.3 cm$^2$/Vs °C. As a result, the on-resistance of MOSFET 100 can be stably suppressed.

In MOSFET 100, a barrier height at an interface between the epitaxial growth layer and gate oxide film 91 may be not less than 2.2 eV and not more than 2.6 eV. As a result, a high channel mobility can be ensured while a leak current is suppressed.

In MOSFET 100, channel resistance which is a resistance value in the channel region formed in each of p type body regions 4 in an on state may be smaller than drift resistance which is a resistance value in the epitaxial growth layer other than p type body regions 4. As a result, the on-resistance of MOSFET 100 can be reduced.

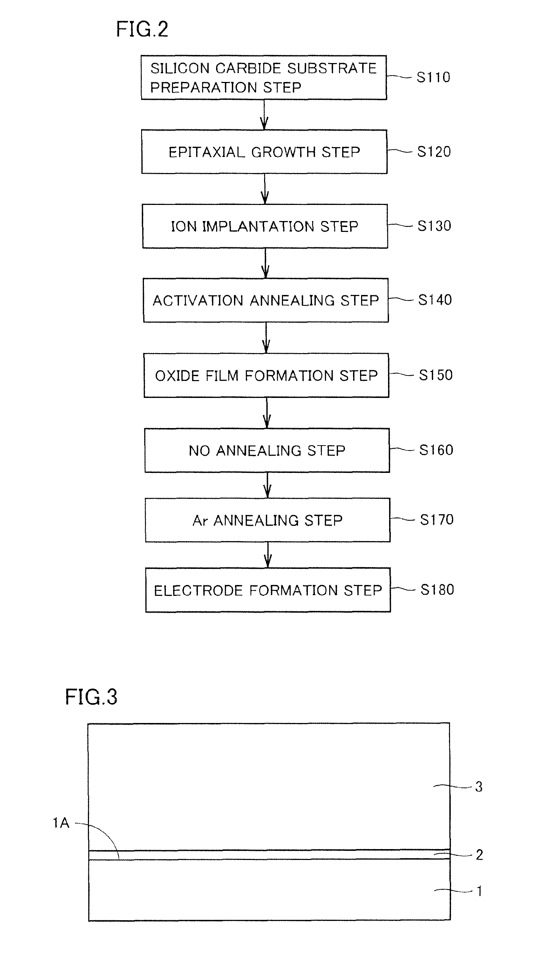

Next, an exemplary method of manufacturing MOSFET 100 in the first embodiment will be described with reference to Figs. 2 to 5. Referring to Fig. 2, in the method of manufacturing MOSFET 100 in this embodiment, a silicon carbide substrate preparation step is first performed as a step (S 110). In this step (S110), referring to Fig. 3, silicon carbide substrate 1 including main surface 1A having an off angle of not less than 50° and not more than 65° with respect to the {0001} plane is prepared.

Next, an epitaxial growth step is performed as a step (S120). In this step (S120), referring to Fig. 3, buffer layer 2 and drift layer 3 made of silicon carbide are successively formed by epitaxial growth on one main surface 1A of silicon carbide substrate 1.

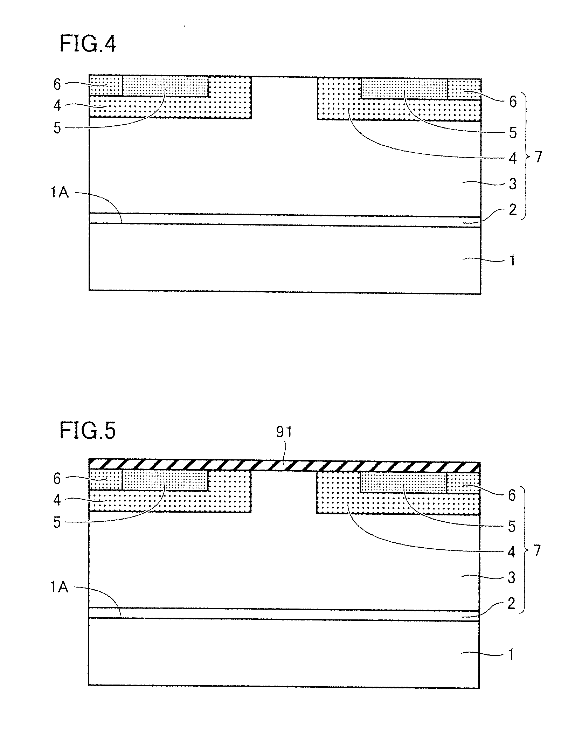

Next, an ion implantation step is performed as a step (S 130). In this step (S130), referring to Figs. 3 and 4, ion implantation for forming p type body regions 4 is first performed. Specifically, Al (aluminum) ions are implanted into drift layer 3, for example, to form p type body regions 4. Then, ion implantation for forming $n^+$ regions 5 is performed. Specifically, P (phosphor) ions are implanted into p type body regions 4, for example, to form $n^+$ regions 5 in p type body regions 4. Further, ion implantation for forming $p^+$ regions 6 is performed. Specifically, Al ions are implanted into p type body regions 4, for example, to form $p^+$ regions 6 in p type body regions 4. Each of these ion implantations can be performed by forming a mask layer, which is made of silicon dioxide ($SiO_2$) and has an opening in a desired region where the ion implantation should be performed, on a main surface of drift layer 3.

Next, an activation annealing step is performed as a step (S 140). In this step (S 140), heat treatment is conducted by heating to 1700°C in an atmosphere of inert gas such as argon and maintaining it for 30 minutes. As a result, the impurities implanted in the above step (S 130) are activated.

Next, an oxide film formation step is performed as a step (S 150). In this step (S 150), referring to Figs. 4 and 5, heat treatment is conducted by heating to 1300°C in an oxygen atmosphere and maintaining it for 60 minutes, to form oxide film (gate oxide film) 91.

Next, a NO annealing step is performed as a step (S160). In this step (S160), heat treatment is conducted by heating in a nitrogen monoxide (NO) gas as an atmosphere gas. The condition for this heat treatment may be such that a temperature of not less than 1100°C and not more than 1300°C is maintained for about one hour. Such heat treatment introduces nitrogen atoms into an interface region between oxide film 91 and drift layer 3. As a result, formation of an interface state in the interface region between oxide film 91 and drift layer 3 is suppressed, thereby improving the channel mobility in finally obtained MOSFET 100. While a process using the NO gas as the atmosphere gas is employed in this embodiment, a process using another gas capable of introducing nitrogen atoms into the interface region between oxide film 91 and drift layer 3 may be employed.

Next, an Ar annealing step is performed as a step (S 170). In this step (S 170), heat treatment is conducted by heating in an argon (Ar) gas as an atmosphere gas. The condition for this heat treatment may be such that a temperature higher than the heating temperature in the above step (S 160) and lower than a melting point of oxide film 91 is maintained for about one hour, for example. As a result of this heat treatment, formation of the interface state in the interface region between oxide film 91 and drift layer 3 is further suppressed, thereby improving the channel mobility in finally obtained MOSFET 100. While a process using the Ar gas as the atmosphere gas is employed in this embodiment, a process using another inert gas such as a nitrogen gas instead of the Ar gas may be employed.

In particular, the condition for the heat treatment in this embodiment may be such that the temperature higher than the heating temperature in the above step (S160) is maintained. Accordingly, carbon atoms as interstitial atoms remaining in the interface region between oxide film 91 and drift layer 3 as a result of forming oxide film 91 may be effectively diffused into drift layer 3. As a result, the channel mobility in finally obtained MOSFET 100 can be further improved.

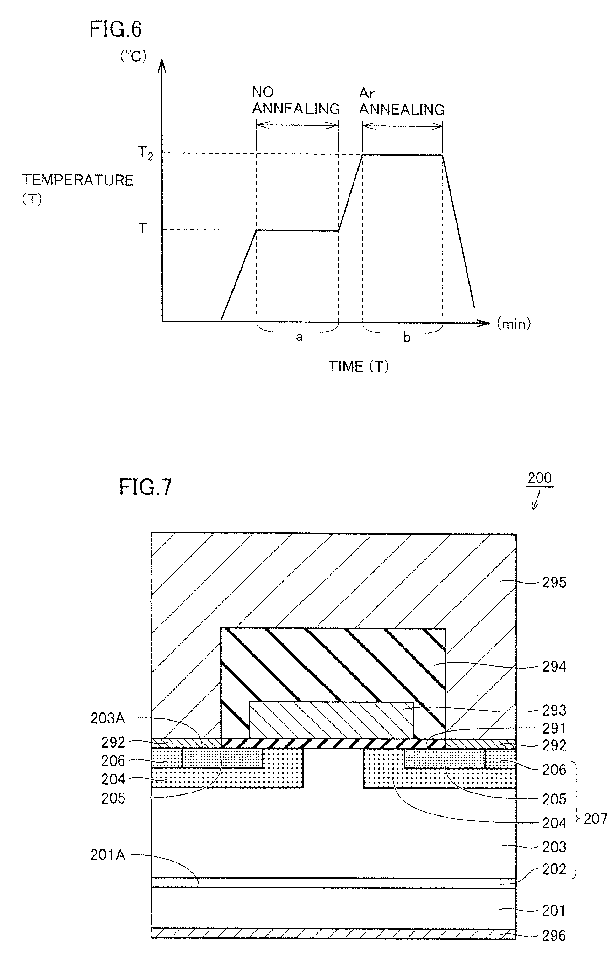

More specifically, the steps (S160) and (S170) can be performed as shown in Fig. 6. In Fig. 6, a horizontal axis represents processing time, and a vertical axis represents temperature (heat treatment temperature). As shown in Fig. 6, in this embodiment, a heat treatment temperature ($T_2$) of Ar annealing (heating time: b) performed as the step (S 170) can be made higher than a heat treatment temperature ($T_1$) of NO annealing (heating time: a) performed as the step (S160). For example, the heat treatment temperature ($T_1$) in the step (S160) can be not less than 900°C and not more than 1400°C, and the heat treatment temperature ($T_2$) in the step (S 170) can be not less than 1000°C and not more than 1500°C, which is higher than the heat treatment temperature ($T_1$).

Next, an electrode formation step is performed as a step (S 180). Referring to Fig. 1, in this step (S180), first, gate electrode 93 made of polysilicon which is a conductor including a highly concentrated impurity is formed by a CVD method, photolithography and etching, for example. Then, interlayer insulating film 94 made of $SiO_2$ which is an insulator is formed by a CVD method, for example, to surround gate electrode 93 above main surface 3A. Then, interlayer insulating film 94 and oxide film 91 in a region where source contact electrodes 92 are to be formed are removed by photolithography and etching. Then, a nickel (Ni) film formed by an evaporation method, for example, is heated and silicidized, to form source contact electrodes 92 and drain electrode 96. Then, source line 95 made of Al which is a conductor is formed by an evaporation method, for example, to surround interlayer insulating film 94 above main surface 3 A and extend to the upper surfaces of $n^+$ regions 5 and source contact electrodes 92. Following the above procedure, MOSFET 100 in this embodiment is completed.

(Second Embodiment)

A second embodiment which is another embodiment of the present invention will now be described. An IGBT 200 which is a semiconductor device in the second embodiment has a similar structure to MOSFET 100 in the first embodiment in terms of plane orientation of the silicon carbide substrate and the p type impurity density in the p type body regions, and thus achieves similar effects.

Namely, referring to Fig. 7, IGBT 200 which is the semiconductor device in this embodiment includes a silicon carbide substrate 201 of the p conductivity type, a buffer layer 202 (which may be of either the n or p conductivity type), a drift layer 203 of the n conductivity type made of silicon carbide, a pair of p type body regions 204 of the p conductivity type, $n^+$ regions 205 of the n conductivity type, and $p^+$ regions 206 of the p conductivity type.

Buffer layer 202 is formed on one main surface 201 A of silicon carbide substrate 201, and contains an impurity in a concentration higher than in drift layer 203. Drift layer 203 is formed on buffer layer 202, and is of the n conductivity type by containing an n type impurity. Buffer layer 202 and drift layer 203 constitute an epitaxial growth layer formed on one main surface 201 A of silicon carbide substrate 201.

The pair of p type body regions 204 is formed apart from each other in the epitaxial growth layer to include a main surface 203A opposite to a main surface closer to silicon carbide substrate 201, and is of the p conductivity type by containing a p type impurity. The p type impurity contained in p type body regions 204 is aluminum (Al) and/or boron (B), for example.

Each of $n^+$ regions 205 is formed in each of the pair of p type body regions 204 to include main surface 203A and be surrounded by each of p type body regions 204. $N^+$ regions 205 contain an n type impurity such as P in a concentration (density) higher than that of the n type impurity contained in drift layer 203. Each of $p^+$ regions 206 is formed in each of the pair of p type body regions 204 to include main surface 203A, be surrounded by each of p type body regions 204, and be adjacent to each of $n^+$ regions 205. $P^+$ regions 206 contain a p type impurity such as Al in a concentration (density) higher than that of the p type impurity contained in p type body regions 204. Buffer layer 202, drift layer 203, p type body regions 204, $n^+$ regions 205 and $p^+$ regions 206 constitute an active layer 207.

Referring to Fig. 7, IGBT 200 further includes a gate oxide film 291 as a gate insulating film, a gate electrode 293, a pair of emitter contact electrodes 292, an interlayer insulating film 294, an emitter line 295, and a collector electrode 296.

Gate oxide film 291 is formed on and in contact with main surface 203A of the epitaxial growth layer to extend from an upper surface of one of $n^+$ regions 205 to an upper surface of the other $n^+$ region 205, and is made of silicon dioxide ($SiO_2$), for example.

Gate electrode 293 is arranged in contact with gate oxide film 291 to extend from above one of $n^+$ regions 205 to above the other $n^+$ region 205. Gate electrode 293 is formed of a conductor such as polysilicon including an impurity or Al.

Each of emitter contact electrodes 292 is arranged in contact with main surface 203A to extend from above each of the pair of $n^+$ regions 205 to reach a portion above each of $p^+$ regions 206. Emitter contact electrodes 292 are made of a material capable of making ohmic contact with both $n^+$ regions 205 and $p^+$ regions 206, such as nickel silicide.

Interlayer insulating film 294 is formed to surround gate electrode 293 above main surface 203A of drift layer 203 and extend from above one of p type body regions 204 to above the other p type body region 204, and is made of silicon dioxide ($SiO_2$) which is an insulator, for example.

Emitter line 295 surrounds interlayer insulating film 294 above main surface 203A of drift layer 203, and extends to upper surfaces of emitter contact electrodes 292. Emitter line 295 is formed of a conductor such as Al, and electrically connected to $n^+$ regions 205 via emitter contact electrodes 292.

Collector electrode 296 is formed in contact with a main surface of silicon carbide substrate 201 opposite to the surface on which drift layer 203 is formed. Collector electrode 296 is made of a material capable of making ohmic contact with silicon carbide substrate 201, such as nickel silicide, and electrically connected to silicon carbide substrate 201.

Next, operation of IGBT 200 will be described. Referring to Fig. 7, when a voltage is applied to gate electrode 293 and the voltage exceeds a threshold value, an inversion layer is formed in each of p type body regions 204 in contact with gate oxide film 291 below gate electrode 293, causing $n^+$ regions 205 and drift layer 203 to be electrically connected to each other. As a result, electrons are supplied from $n^+$ regions 205 into drift layer 203, and holes are accordingly supplied from silicon carbide substrate 201 to drift layer 203 via buffer layer 202. Consequently, IGBT 200 is turned on, conductivity modulation occurs in drift layer 203, and a current flows with reduced resistance between emitter contact electrodes 292 and collector electrode 296. On the other hand, when the voltage applied to gate electrode 293 is lower than the threshold voltage, the inversion layer is not formed so that a junction between drift layer 203 and each of p type body regions 204 remains reverse biased. Consequently, IGBT 200 is turned off, not causing a current flow.

In IGBT 200, main surface 201A of silicon carbide substrate 201 has an off angle of not less than 50° and not more than 65° with respect to the {0001} plane. Accordingly, even if highly doped p type body regions 204 having a p type impurity density of not less than $5 \times 10^{16}$ cm$^{-3}$ are formed and the threshold voltage is shifted to a positive side, reduction in mobility of carriers (electrons) (channel mobility) in the channel region is suppressed. Therefore, a high threshold voltage can be set while reduction in channel mobility is suppressed in IGBT 200. Silicon carbide substrate 201 and p type body regions 204 in this embodiment correspond to silicon carbide substrate 1 and p type body regions 4 in the first embodiment, respectively. In addition, silicon carbide substrate 1 and silicon carbide substrate 201 are similar to each other in plane orientation, and p type body regions 4 and p type body regions 204 are similar to each other in p type impurity density.

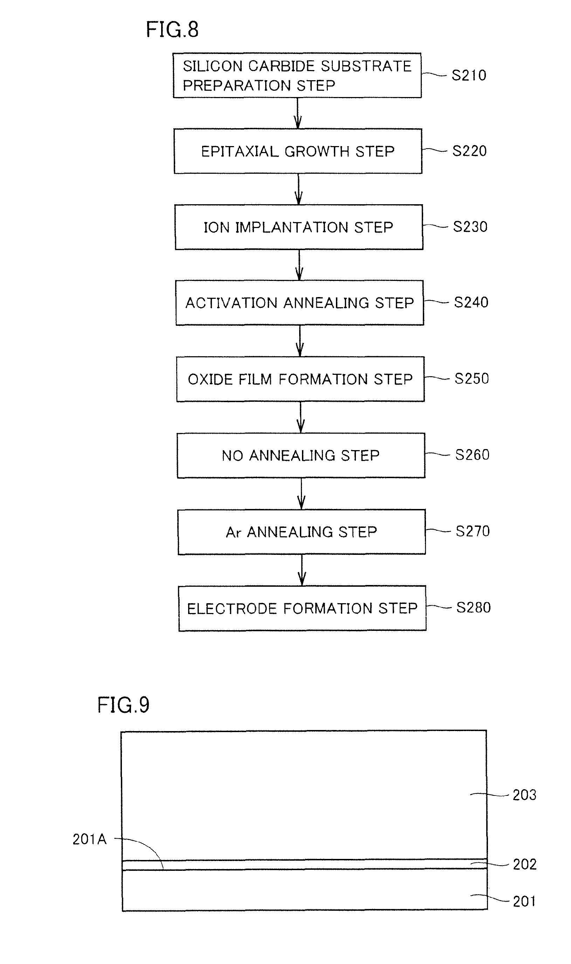

Next, an exemplary method of manufacturing IGBT 200 in the second embodiment will be described with reference to Figs. 8 to 11. Referring to Fig. 8, in the method of manufacturing IGBT 200 in this embodiment, a silicon carbide substrate preparation step is first performed as a step (S210). In this step (S210), referring to Fig. 9, silicon carbide substrate 201 including main surface 201 A having an off angle of not less than 50° and not more than 65° with respect to the {0001} plane is prepared.

Next, an epitaxial growth step is performed as a step (S220). In this step (S220), referring to Fig. 9, buffer layer 202 and drift layer 203 are successively formed by epitaxial growth on one main surface 201 A of silicon carbide substrate 201.

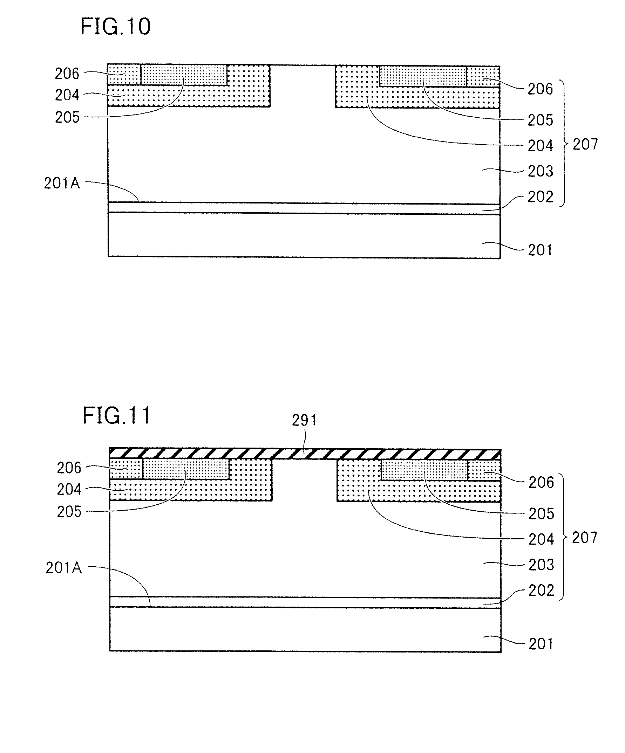

Next, an ion implantation step is performed as a step (S230). In this step (S230), referring to Figs. 9 and 10, ion implantation for forming p type body regions 204 is first performed. Specifically, Al (aluminum) ions are implanted into drift layer 203, for example, to form p type body regions 204. Then, ion implantation for forming $n^+$ regions 205 is performed. Specifically, P (phosphor) ions are implanted into p type body regions 204, for example, to form $n^+$ regions 205 in p type body regions 204. Further, ion implantation for forming $p^+$ regions 206 is performed. Specifically, Al ions are implanted into p type body regions 204, for example, to form $p^+$ regions 206 in p type body regions 204. Each of these ion implantations can be performed by forming a mask layer, which is made of silicon dioxide ($SiO_2$) and has an opening in a desired region where the ion implantation should be performed, on a main surface of drift layer 203.

Next, an activation annealing step is performed as a step (S240). In this step (S240), heat treatment is conducted by heating to 1700°C in an atmosphere of inert gas such as argon and maintaining it for 30 minutes. As a result, the impurities implanted in the above step (S230) are activated.

Next, an oxide film formation step is performed as a step (S250). In this step (S250), referring to Figs. 10 and 11, heat treatment is conducted by heating to 1300°C in an oxygen atmosphere and maintaining it for 60 minutes, to form oxide film (gate oxide film) 291.

Next, a NO annealing step and a Ar annealing step are performed as steps (S260) and (S270). These steps (S260) and (S270) can be performed in a manner similar to the steps (S160) and (S170) in the first embodiment. As a result, the channel mobility in finally obtained IGBT 200 can be improved.

Next, an electrode formation step is performed as a step (S280). Referring to Fig. 7, in this step (S280), gate electrode 293 made of polysilicon which is a conductor including an impurity is formed by a CVD method, for example, and then interlayer insulating film 294 made of $SiO_2$ which is an insulator is formed by a CVD method, for example, to surround gate electrode 293 above main surface 203A. Then, a nickel (Ni) film formed by an evaporation method, for example, is heated and silicidized, to form emitter contact electrodes 292 and collector electrode 296. Then, emitter line 295 made of Al which is a conductor is formed by an evaporation method, for example, to surround interlayer insulating film 294 above main surface 203A and extend to the upper surfaces of $n^+$ regions 205 and emitter contact electrodes 292. Following the above procedure, IGBT 200 in this embodiment is completed.

(First Example)

Experiments were conducted to confirm relation between a doping density of a p type impurity in a p type body region and a threshold voltage. Specifically, first, experimental MOSFETs (samples) were fabricated by a process including a NO annealing step and a Ar annealing step as in the first embodiment. A plurality of samples with different doping densities of a p type impurity in a p type body region were fabricated. Then, a threshold voltage was measured for each sample.

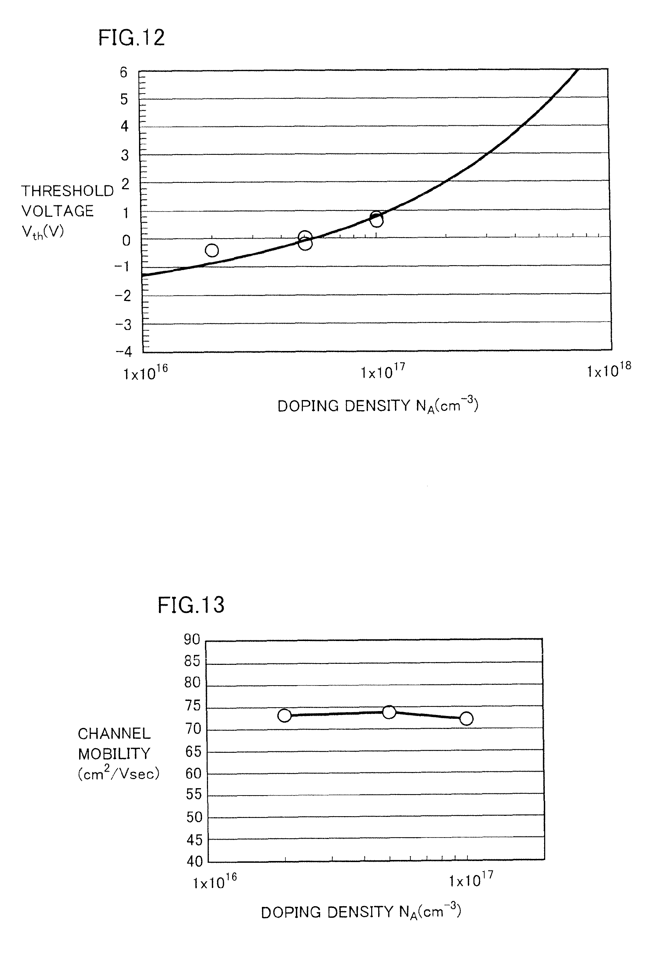

The experimental results are shown in Fig. 12. In Fig. 12, a horizontal axis represents the doping density of the p type impurity in the p type body region, and a vertical axis represents the threshold voltage. Circles in Fig. 12 are data points obtained from the experiments. A curve in Fig. 12 is a theoretical curve indicating the relation between the doping density and the threshold voltage. The theoretical curve corresponds to an expression (1) indicated below. In the expression (1), $n_i$ represents an intrinsic carrier density, $C_{ox}$ represents an oxide film capacity, $\phi_m$ and $\phi_s$ represent work functions of a metal and a semiconductor, respectively, and $\Delta V_{Qeff}$ represents a voltage shift component due to effective fixed charge. In addition, Q represents an elementary charge (Q = $1.6 \times 10^{-19}$ C). From the experimental results, $\Delta V_{Qeff}$ = 1.9 V was used.

$$V_{th}(N_a) = \frac{\sqrt{2\varepsilon_o\varepsilon_{sic}kTN_a\ln\left(\dfrac{N_a}{n_i}\right)}}{C_{ox}} + \frac{kT}{Q}\ln\left(\frac{N_a}{n_i}\right) + (\phi_m - \phi_s) + \Delta V_{Qeff}$$

$$\cdots(1)$$

Referring to Fig. 12, the data points obtained from the experiments are distributed along the theoretical curve. It can be seen from Fig. 12 that a positive threshold voltage is stably obtained, that is, a normally off device is realized, by setting the doping density of the p type impurity in the p type body region to not less than $8 \times 10^{16}$ cm$^{-3}$

(Second Example)

Experiments were conducted to examine relation between a doping density of a p type impurity in a p type body region and a channel mobility. The experimental procedure was as follows.

First, MOSFET samples were fabricated by preparing a silicon carbide substrate having one main surface whose plane orientation is the (0-33-8) plane, and forming an epitaxial growth layer and the like on the main surface. A plurality of samples with doping densities of the p type impurity in the p type body region that vary within a range of from $2 \times 10^{16}$ cm$^{-3}$ to $1 \times 10^{17}$ cm$^{-3}$ were fabricated. A gate oxide film was formed by heating to 1200 to 1300°C in an oxygen atmosphere and maintaining it for about 60 minutes. Then, a NO annealing process was performed by heating to 1100 to 1200°C in a NO atmosphere and maintaining it for about 60 minutes. After that, a Ar annealing process was performed by heating to 1200 to 1300°C in a Ar atmosphere and maintaining it for about 60 minutes (example).

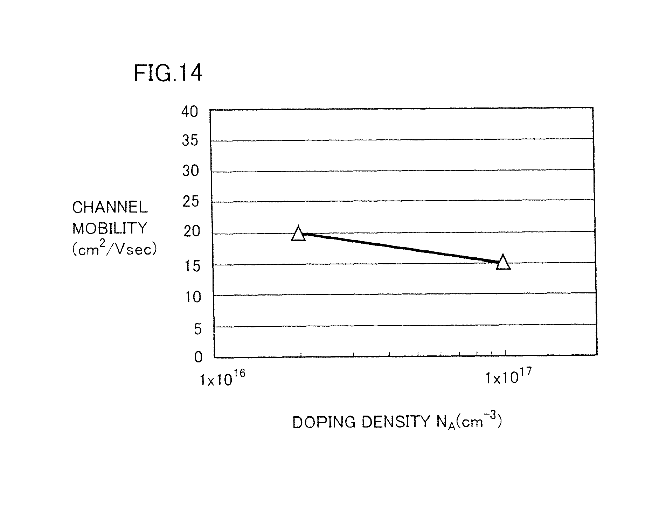

For comparison, MOSFET samples were similarly fabricated by preparing a silicon carbide substrate having one main surface whose plane orientation is the (0001) plane (comparative example). Then, a channel mobility in each sample was measured. The experimental results are shown in Figs. 13 and 14. In Figs. 13 and 14, a horizontal axis represents the doping density of the p type impurity in the p type body region, and a vertical axis represents the channel mobility in the MOSFET.

Referring to Fig. 14, in the MOSFETs of the comparative example which were obtained by forming an epitaxial growth layer and the like on the main surface whose plane orientation is the (0001) plane, the channel mobility decreases by approximately 25% as the doping density increases from $2 \times 10^{16}$ cm$^{-3}$ to $1 \times 10^{17}$ cm$^{-3}$. In the MOSFETs of the example which were obtained by forming an epitaxial growth layer and the like on the main surface whose plane orientation is the (0-33-8) plane, on the other hand, the channel mobility hardly decreases as the doping density increases from $2 \times 10^{16}$ cm$^{-3}$ to $1 \times 10^{17}$ cm$^{-3}$ Further, the channel mobility in the MOSFETs of the example is much higher in absolute value than the channel mobility in the MOSFETs of the comparative example. It can therefore be seen that the semiconductor devices of the example have a higher channel mobility than the semiconductor devices of the comparative example, with the difference between them becoming larger as the doping density in the p type body region increases. It was confirmed from these experimental results that in the semiconductor device of the present invention, the threshold voltage can be shifted to a positive side while reduction in channel mobility is suppressed.

(Third Example)

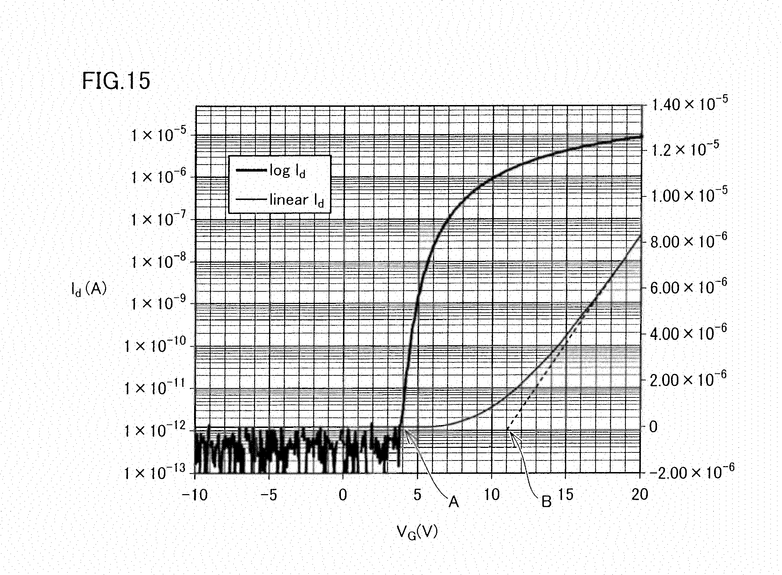

Experiments were conducted to examine a threshold voltage of a MOSFET which is the semiconductor device of the present invention. A subject MOSFET was manufactured by the manufacturing method described in the first embodiment. With this MOSFET, values of a drain current with a varying gate voltage were measured. Then, a graph which plots the measurement results was created, and a threshold voltage was determined from the graph. The threshold voltage was determined by plotting the drain current in a log scale and in a linear scale for the same measurement result. The created graph is shown in Fig. 15.

In Fig. 15, a horizontal axis represents the gate voltage ($V_G$), a left vertical axis represents the drain current in the log scale ($I_d$), and a right vertical axis represents the drain current in the linear scale ($I_d$). In Fig. 15, a heavy line represents the drain current in the log scale (log $I_d$), and a thin line represents the drain current in the linear scale (linear $I_d$). Referring to Fig. 15, a threshold voltage (see point A) obtained from a curve indicating the drain current in the log scale is smaller than a threshold voltage (see point B) obtained by extending a straight portion of a curve indicating the drain current in the linear scale. The threshold voltage obtained by the curve indicating the drain current in the log scale indicates a voltage at which a thin channel region (weak inversion layer) is first formed in a region in a p type body region which is in contact with a gate oxide film as a gate voltage is increased. In the present application, the gate voltage at which this weak inversion layer is formed is regarded as the threshold voltage.

(Fourth Example)

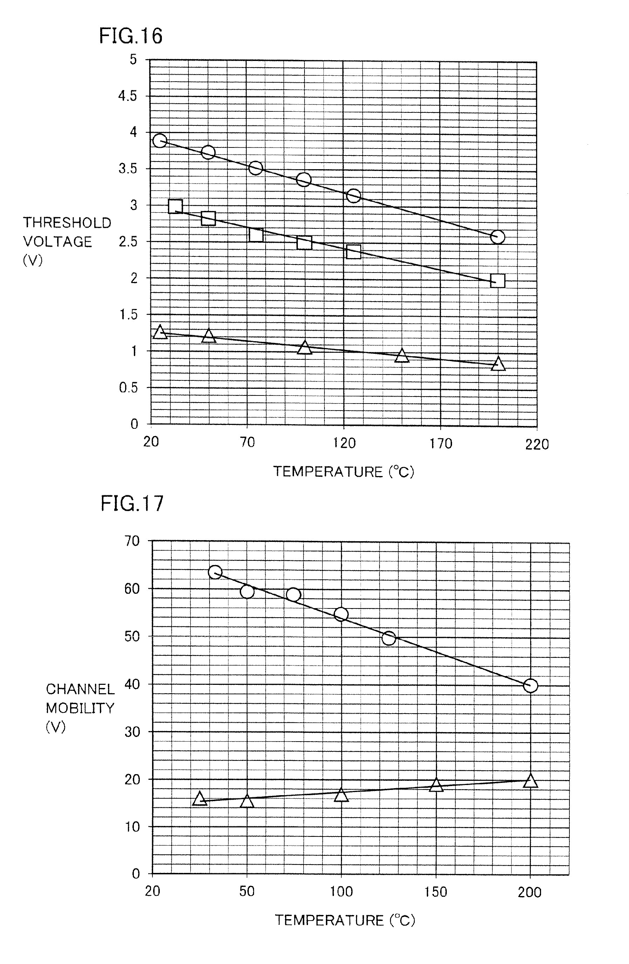

A MOSFET which is the semiconductor device of the present invention was fabricated, and experiments were conducted to examine temperature dependence of a threshold voltage. First, MOSFETs were fabricated in a similar manner as in the first embodiment. Here, an epitaxial growth layer was formed on the {03-38} plane of a carbon face side (i.e., the (0-33-8) plane) of a silicon carbide substrate. Two types of MOSFETs in which a p type impurity (Al) density in a p type body region is $1 \times 10^{18}$ cm$^{-3}$ (example A) and $5 \times 10^{17}$ cm$^{-3}$ (example B) were fabricated. For comparison, a MOSFET including an epitaxial growth layer formed on the {0001} plane of a silicon face side (i.e., the (0001) plane) of a silicon carbide substrate was also fabricated by a similar manufacturing method (comparative example A). A p type impurity (Al) density in the p type body region was set to $2 \times 10^{16}$ cm$^{-3}$. Then, threshold voltages of the MOSFETs in the examples and the comparative example were determined within a temperature range of from not less than room temperature (25°C) to 200°C. The examination results are shown in Fig. 16. In Fig. 16, circles indicate the examination results of example A, squares indicate the examination results of example B, and triangles indicate the examination results of comparative example A.

Referring to Fig. 16, the threshold voltages of the MOSFETs in examples A and B are higher than that in the comparative example, which are not less than 2 V within a temperature range of from not less than room temperature and not more than 100°C. Thus, a normally off state can be stably maintained. In particular, the threshold voltage of the MOSFET in example A is not less than 3V at 100°C and not less than 1 V at 200°C. Thus, a normally off state can be stably maintained at a higher temperature. In examples A and B, the threshold voltage has a temperature dependence (inclination of an approximate line in the figure) of -7 mV/°C and -6 mV/°C, respectively, which is not less than -10 mV/°C. To explain from another point of view, an absolute value of the temperature dependence (inclination of the approximate line in the figure) is 7 mV/°C and 6 mV/°C in examples A and B, respectively, which is not more than 10 mV/°C. Consequently, a normally off state can be stably maintained.

(Fifth Example)

A MOSFET which is the semiconductor device of the present invention was fabricated, and experiments were conducted to examine a temperature dependence of a channel mobility of electrons. First, a MOSFET was fabricated in a similar manner as in the first embodiment. Here, an epitaxial growth layer was formed on the {03-38} plane of a carbon face side (i.e., the (0-33-8) plane) of a silicon carbide substrate (example C). For comparison, a MOSFET including an epitaxial growth layer formed on the {0001} plane of a silicon face side (i.e., the (0001) plane) of a silicon carbide substrate was also fabricated by a similar manufacturing method (comparative example B). Then, the channel mobilities of electrons in the MOSFETs of the example and the comparative example were examined within a temperature range of from not less than room temperature (25°C) to 200°C. The examination results are shown in Fig. 17. In Fig. 17, circles indicate the examination results of example C, and triangles indicate the examination results of comparative example B.

Referring to Fig. 17, the channel mobility in the MOSFET of example C is higher than that in comparative example B, and is not less than 30 cm$^2$/Vs at room temperature, not less than 50 cm$^2$/Vs at 100°C, and not less than 40 cm$^2$/Vs at 150°C. The temperature dependence of the channel mobility of electrons is not less than -0.3 cm$^2$/Vs °C. To explain from another point of view, an absolute value of the temperature dependence of the channel mobility of electrons is not more than 0.3 cm$^2$/Vs °C. Consequently, on-resistance of the semiconductor device can be stably suppressed.

(Sixth Example)

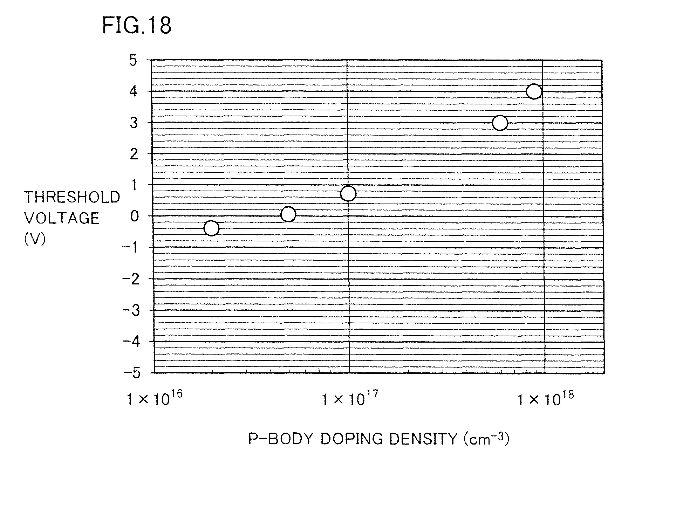

A MOSFET which is the semiconductor device of the present invention was fabricated, and experiments were conducted to examine relation between a p type impurity (Al) density in a p type body region and a threshold voltage. First, MOSFETs was fabricated in a similar manner as in the first embodiment. Here, an epitaxial growth layer was formed on the {03-38} plane of a carbon face side (i.e., the (0-33-8) plane) of a silicon carbide substrate. Five types of samples with different p type impurity (Al) densities in the p type body region were fabricated. Then, channel mobilities of electrons in the samples were examined. The examination results are shown in Fig. 18. In Fig. 18, a horizontal axis represents the p type impurity (Al) density in the p type body region, and a vertical axis represents the threshold voltage.

Referring to Fig. 18, the threshold voltage increases as the impurity density in the p type body region increases. The threshold voltage is approximately 0 to 5 V in an area where the impurity density is not less than $8 \times 10^{16}$ cm$^{-3}$ and not more than $3 \times 10^{18}$ cm$^{-3}$ Further, as described above, since the p type impurity density in the p type body region can be increased while reduction in channel mobility is suppressed in the semiconductor device of the present invention, a sufficient channel mobility can be ensured even if the impurity density is approximately $8 \times 10^{16}$ cm$^{-3}$ to $3 \times 10^{18}$ cm$^{-3}$ Therefore, by setting the p type impurity density in the p type body region to not less than $8 \times 10^{16}$ cm$^{-3}$ and not more than $3 \times 10^{18}$ cm$^{-3}$, a semiconductor device made of silicon can be readily replaced with the semiconductor device of the present invention for use, and a normally off state can be stably maintained. Moreover, significant reduction in channel mobility resulting from increase in impurity density can be avoided.

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

INDUSTRIAL APPLICABILITY

The semiconductor device of the present invention can be applied particularly advantageously to a semiconductor device for which increased flexibility in setting a threshold voltage is required.

REFERENCE SIGNS LIST

1, 201 silicon carbide substrate; 1A, 201A main surface; 2, 202 buffer layer; 3, 203 drift layer; 3A, 203A main surface; 4, 204 p type body region; 5, 205 n$^+$ region; 6, 206 p$^+$ region; 7, 207 active layer; 91, 291 gate oxide film (oxide film); 92 source contact electrode; 93 gate electrode; 94, 294 interlayer insulating film; 95 source line; 96 drain electrode; 100 MOSFET; 200 IGBT; 292 emitter contact electrode; 293 gate electrode; 295 emitter line; 296 collector electrode.

**Claims**

**1.** A semiconductor device (100, 200) comprising:

a silicon carbide substrate (1, 201) including a main surface (1A, 201A) having an off angle of not less than 50° and not more than 65° with respect to a {0001} plane;
an epitaxial growth layer (7, 207) of a first conductivity type formed on said main surface (1A, 201 A);
an insulating film (91, 291) formed on and in contact with said epitaxial growth layer (7, 207); and
a body region (4, 204) of a second conductivity type different from said first conductivity type formed in said epitaxial growth layer (7, 207) to include a region in contact with said insulating film (91, 291),
said body region (4, 204) having an impurity density of not less than $5 \times 10^{16}$ cm$^{-3}$.

**2.** The semiconductor device (100, 200) according to claim 1, wherein
an angle formed between an off orientation of said main surface (1A, 201A) and a <01-10> direction is not more than 5°.

**3.** The semiconductor device (100, 200) according to claim 2, wherein
said main surface (1A, 201A) has an off angle of not less than -3° and not more than 5° with respect to a {03-38} plane in the <01-10> direction.

**4.** The semiconductor device (100, 200) according to claim 1, wherein
an angle formed between an off orientation of said main surface (1A, 201 A) and a <-2110> direction is not more than 5°.

**5.** The semiconductor device (100, 200) according to claim 1, wherein
said main surface (1A, 201 A) is a surface of a carbon face side of silicon carbide forming said silicon carbide substrate (1, 201).

**6.** The semiconductor device (100, 200) according to claim 1, wherein
said body region (4, 204) has an impurity density of not more than $1 \times 10^{20}$ cm$^{-3}$.

**7.** The semiconductor device (100, 200) according to claim 1, being of a normally off type.

**8.** The semiconductor device (100, 200) according to claim 7, further comprising a gate electrode (93, 293) arranged on and in contact with said insulating film (91, 291), wherein
said gate electrode (93, 293) is made of polysilicon of said second conductivity type.

9. The semiconductor device (100, 200) according to claim 1, further comprising a gate electrode (93, 293) arranged on and in contact with said insulating film (91, 291), wherein
said gate electrode (93, 293) is made of n type polysilicon.

10. The semiconductor device (100, 200) according to claim 1, wherein
said insulating film (91, 291) has a thickness of not less than 25 nm and not more than 70 nm.

11. The semiconductor device (100, 200) according to claim 1, wherein
said first conductivity type is an n type, and said second conductivity type is a p type.

12. The semiconductor device (100, 200) according to claim 11, wherein
said body region (4, 204) has an impurity density of not less than $8 \times 10^{16}$ cm$^{-3}$ and not more than $3 \times 10^{18}$ cm$^{-3}$

13. The semiconductor device (100, 200) according to claim 11, wherein
a threshold voltage at which a weak inversion layer is formed in a region in said body region (4, 204) which is in contact with said insulating film (91, 291) is not less than 2 V within a temperature range of from not less than room temperature and not more than 100°C.

14. The semiconductor device (100, 200) according to claim 13, wherein
said threshold voltage is not less than 3 V at 100°C.

15. The semiconductor device (100, 200) according to claim 13, wherein
said threshold voltage is not less than 1 V at 200°C.

16. The semiconductor device (100, 200) according to claim 13, wherein
said threshold voltage has a temperature dependence of not less than -10 mV/°C.

17. The semiconductor device (100, 200) according to claim 11, wherein
a channel mobility of electrons at room temperature is not less than 30 cm$^2$/Vs.

18. The semiconductor device (100, 200) according to claim 17, wherein
the channel mobility of electrons at 100°C is not less than 50 cm$^2$/Vs.

19. The semiconductor device (100, 200) according to claim 17, wherein
the channel mobility of electrons at 150°C is not less than 40 cm$^2$/Vs.

20. The semiconductor device (100, 200) according to claim 17, wherein
the channel mobility of electrons has a temperature dependence of not less than -0.3 cm$^2$/Vs °C.

21. The semiconductor device (100, 200) according to claim 1, wherein
a barrier height at an interface between said epitaxial growth layer (7, 207) and said insulating film (91, 291) is not less than 2.2 eV and not more than 2.6 eV.

22. The semiconductor device (100, 200) according to claim 1, wherein
channel resistance which is a resistance value in a channel region formed in said body region (4, 204) in an on state is smaller than drift resistance which is a resistance value in said epitaxial growth layer (7, 207) other than said channel region.

23. The semiconductor device (100) according to claim 1, being a DiMOSFET.

FIG.1

FIG.2

SILICON CARBIDE SUBSTRATE PREPARATION STEP — S110

EPITAXIAL GROWTH STEP — S120

ION IMPLANTATION STEP — S130

ACTIVATION ANNEALING STEP — S140

OXIDE FILM FORMATION STEP — S150

NO ANNEALING STEP — S160

Ar ANNEALING STEP — S170

ELECTRODE FORMATION STEP — S180

FIG.3

FIG.4

FIG.5

FIG.6

(°C)

T₂ ‥‥‥‥‥‥‥‥‥‥

TEMPERATURE
(T)

T₁ ‥‥‥‥

NO
ANNEALING

Ar
ANNEALING

a          b

(min)

TIME (T)

FIG.7

200

295

294

293
291
292

203A
292
206
204
205

206
205
204          207

201A

203
202

201

296

# FIG.8

```
┌─────────────────────────────┐
│  SILICON CARBIDE SUBSTRATE  │──── S210
│      PREPARATION STEP       │
└─────────────────────────────┘
              │
              ▼
┌─────────────────────────────┐
│    EPITAXIAL GROWTH STEP    │──── S220
└─────────────────────────────┘
              │
              ▼
┌─────────────────────────────┐
│    ION IMPLANTATION STEP    │──── S230
└─────────────────────────────┘
              │
              ▼
┌─────────────────────────────┐
│  ACTIVATION ANNEALING STEP  │──── S240
└─────────────────────────────┘
              │
              ▼
┌─────────────────────────────┐
│  OXIDE FILM FORMATION STEP  │──── S250
└─────────────────────────────┘
              │
              ▼
┌─────────────────────────────┐
│      NO ANNEALING STEP      │──── S260
└─────────────────────────────┘
              │
              ▼
┌─────────────────────────────┐
│      Ar ANNEALING STEP      │──── S270
└─────────────────────────────┘
              │
              ▼
┌─────────────────────────────┐
│  ELECTRODE FORMATION STEP   │──── S280
└─────────────────────────────┘
```

# FIG.9

```
                          ┌──────────────────────────┐
                          │                          │
                          │                          │──── 203
                          │                          │
              201A ───────┤                          │
                          ├──────────────────────────┤──── 202
                          │                          │──── 201
                          └──────────────────────────┘
```

## FIG.10

## FIG.11

FIG.12

FIG.13

FIG.14

CHANNEL
MOBILITY
$(cm^2/Vsec)$

DOPING DENSITY $N_A(cm^{-3})$

FIG.15

EP 2 600 402 A1

FIG.16

FIG.17

FIG.18

THRESHOLD VOLTAGE (V) vs P-BODY DOPING DENSITY (cm$^{-3}$)

## INTERNATIONAL SEARCH REPORT

| | International application No. |
|---|---|
| | PCT/JP2011/064897 |

A. CLASSIFICATION OF SUBJECT MATTER
*H01L29/12*(2006.01)i, *H01L29/78*(2006.01)i

According to International Patent Classification (IPC) or to both national classification and IPC

B. FIELDS SEARCHED

Minimum documentation searched (classification system followed by classification symbols)
H01L29/12, H01L29/78

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2002-261275 A  (Sixon Inc.),<br>13 September 2002 (13.09.2002),<br>paragraphs [0017], [0039] to [0047]; fig. 3, 4,<br>11<br>(Family: none) | 1-4,6-23<br>5 |
| X<br>Y | JP 2010-41021 A  (Sumitomo Electric Industries,<br>Ltd.),<br>18 February 2010 (18.02.2010),<br>paragraphs [0125] to [0142]; fig. 3 to 13<br>(Family: none) | 1-4,6-23<br>5 |
| Y | WO 2001/018872 A1  (Sixon Inc.),<br>15 March 2001 (15.03.2001),<br>example 4; fig. 9, 11<br>& JP 3854508 B          & EP 1215730 A1<br>& DE 60033829 D        & TW 565630 B | 5 |

☐ Further documents are listed in the continuation of Box C. ☐ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 26 September, 2011 (26.09.11) | 11 October, 2011 (11.10.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
|---|
| PCT/JP2011/064897 |

| **Box No. II** | **Observations where certain claims were found unsearchable (Continuation of item 2 of first sheet)** |
|---|---|

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| **Box No. III** | **Observations where unity of invention is lacking (Continuation of item 3 of first sheet)** |
|---|---|

This International Searching Authority found multiple inventions in this international application, as follows:
   The document 1 (JP 2002-261275 A (Sixon Inc.), 13 September 2002 (13.09.2002), [0017], [0039]-[0047], fig. 3, 4, 11, (Family: none)), and the document 2 (JP 2010-41021 A (Sumitomo Electric Industries, Ltd.), 18 February 2010 (18.02.2010), [0125]-[0142], fig. 3-13, (Family: none)) disclose semiconductor device set forth in claim 1. Therefore, the invention in claim 1 cannot be considered to be novel in the light of the invention described in the document 1, and does not have a special technical feature.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SEI-HYUNG RYU et al.** Critical Issues for MOS Based Power Devices in 4H-SiC. *Materials Science Forum,* 2009, vol. 615-617, 743-748